Europäisches Patentamt

European Patent Office

Office européen des brevets

(19)

(11) **EP 0 715 412 B1**

(12) **EUROPÄISCHE PATENTSCHRIFT**

(45) Veröffentlichungstag und Bekanntmachung des Hinweises auf die Patenterteilung:
**28.01.1998  Patentblatt 1998/05**

(51) Int Cl.⁶: **H03L 7/08**, H03L 7/18

(21) Anmeldenummer: **95117864.9**

(22) Anmeldetag: **13.11.1995**

(54) **Verfahren und Anordnung zur Ermittlung von Phasenänderungen eines Referenz-Eingangssignals eines Phasenregelkreises**

Process and arrangement for the investigation of phase variations of a reference input signal of a phase locked loop

Procédé et dispositif d'investigation des variations de phase du signal d'entrée de référence d'une boucle à verrouillage de phase

(84) Benannte Vertragsstaaten:
**BE CH DE FR GB IT LI NL**

(30) Priorität: **28.11.1994  DE 4442306**

(43) Veröffentlichungstag der Anmeldung:
**05.06.1996  Patentblatt 1996/23**

(73) Patentinhaber: **SIEMENS AKTIENGESELLSCHAFT**
**80333 München (DE)**

(72) Erfinder:
• **Dietrich, Werner, Dipl.-Ing.**
  **A-1210 Wien (AT)**
• **Jenkner, Christian, Dipl.-Ing.**
  **A-1070 Wien (AT)**

(56) Entgegenhaltungen:
**DE-A- 2 735 011          US-A- 3 895 294**

• **PATENT ABSTRACTS OF JAPAN vol. 18 no. 376 (P-1770) ,14.Juli 1994 & JP-A-06 102964 (HITACHI LTD) 15.April 1994, & US-A-5 455 840 (NAKAUCHI ET AL.) 3.Oktober 1995**

**Beschreibung**

Die Erfindung betrifft ein Verfahren zur Ermittlung von Phasenänderungen eines Referenz-Eingangssignals entsprechend dem Oberbegriff des Anspruches 1 und eine Anordnung hierzu entsprechend dem Oberbegriff des unabhängigen Anordnungsanspruchs 7.

Im synchronen digitalen Kommunikationsnetzen werden an Vermittlungsstellen und Netzknoten Netztaktreferenzsignale benötigt. An Referenzfrequenzen werden bezüglich der Stabilität besonders hohe Anforderungen gestellt, die erforderlich sind, um eine problemlose Übertragung der Daten zu ermöglichen. Die benötigte Langzeitstabilität kann zur Zeit nur durch Cäsium-Atomfrequenznormale garantiert werden.

Aus Gründen der Wirtschaftlichkeit werden in den digitalen Kommunikationsnetzen von einem nationalen Frequenznormal synchronisierte Taktgeneratoren verwendet. Bei sogenannten Slave-Einrichtungen wird das Taktsignal aus den übertragenen Signalen durch Synchronisation des Taktgenerators wiedergewonnen. Durch diese Art der Takterzeugung kann aber die gewünschte phasenstarre Kopplung der Taktsignale im synchronen System beeinträchtigt werden. Bei den in der Regel verwendeten Phasenregelkreisen (Phase-Locked-Loop - PLL) gilt der Grundsatz, daß bei höheren Grenzfrequenzen die Kopplung zwischen Eingangssignal und Ausgangstaktsignal starrer wird. Andererseits muß bei Ausfall des synchronisierenden Signals, beispielsweise durch eine gestörte Übertragungsstrecke, der mit der PLL-Schaltung ausgerüstete Regenerator in den sogannten Speicherbetrieb übergehen und selbst ein möglichst frequenzgenaues Taktsignal liefern. Die mögliche Stabilität dieses Taktes ist jedoch wieder um so größer, je kleiner die Grenzfrequenz des Phasenregelkreises ist. Aus diesem Grund werden Taktregeneratoren mit unterschiedlichen Grenzfrequenzen zur Synchronisation verwendet. Damit ein Regenerator in den Speicherbetrieb übergeht, in dem er einen stabilen Takt liefert, ist es zunächst erforderlich, die Konstanz des ankommenden Signals zu ermitteln und zu überprüfen. Bei raschen und relativ großen Frequenzänderungen kann durch Vergleich des Eingangssignals mit dem regenerierten Ausgangssignal in konstanten Zeitabständen eine Phasendifferenz und aus dieser die Frequenzabweichung ermittelt werden. Aufgrund dieser Methoden können größere Frequenzabweichungen als ca. $10^{-7}$ erkannt werden. Schwieriger wird die Ermittlung kleinerer Frequenzabweichungen, wenn die notwendigen Beobachtungszeiten größer gewählt werden müssen. In diesen Fällen folgt bei der PLL-Regelschaltung das Ausgangstaktsignal dem Eingangssignal und kann nicht mehr als starr angesehen werden.

Eine Möglichkeit zur Ermittlung kleiner Phasen- bzw. Frequenzänderungen ist die Verwendung von einem Referenzsignal unabhängiger eigener hochkonstanter Referenzoszillatoren. Nachteilig sind bei diesem Vorschlag die zusätzlichen Kosten für einen Oszillator, der die erforderliche Frequenzkonstanz aufweist.

*In der Auslegeschrift DE-B1-27 35 011 ist eine Schaltungsanordnung zur Überwachung von Eingangssignalen eines Phasenregelkreises angegeben. Diese Schaltung ermittelt während vorgegebener Meßzeiten aufgrund der Regelabweichung die mittlere Phasendifferenz und die mittlere Frequenzdiffenz zwischen einem Eingangssignal und einem Ausgangssignal. Falls vorgegebene Grenzwerte überschritten werden, wird eine Störung angenommen und der Regelvorgang unterbrochen.*

*Die Schaltungsanordnung ist nicht für das Erkennen geringfügiger Freqenzabweichungen konzipiert.*

Aufgabe der Erfindung ist es, ein Verfahren zur Ermittlung von kleinen Phasen- *bzw. Frequenz*änderungen am Eingang einer PLL-Schaltung anzugeben. Außerdem ist eine zur Durchführung des Verfahrens geeignete Anordnung anzugeben.

Die Aufgabe wird durch ein Verfahren nach Anspruch 1 gelöst. In dem unabhängigen Anspruch 7 ist eine geeignete Anordnung angegeben.

Der Vorteil des erfindungsgemäßen Verfahrens liegt in seiner einfachen Realisierbarkeit. Ein Vergleichsoszillator ist nicht erforderlich.

Die Berechnung der Phasenänderung des Eingangssignals - aus der wiederum die Frequenzabweichung ermittelt werden kann - erfolgt aufgrund der mathematischen Beziehungen zwischen den Signalen und den Parametern der Regelschleife. Die mathematischen Operationen können durch eine analoge Rechenschaltung oder durch ein digitales Rechenwerk bzw. einen Prozessor ermittelt werden. Ebenso sind Kombinationen möglich.

Vorteilhaft ist die Ermittlung des Zeitintegrals über die Phasenabweichung bzw. der entsprechenden Summe in einem digitalen Hardware-Integrator und die Ausführung der endgültigen Berechnung in einem Prozessor.

Dabei kann oft auf die Berechnung des Anteils aus dem Doppelintegral verzichtet werden, da dieses bei hohen Dämpfungswerten vernachlässigbar ist.

Sobald der ermittelte Wert für die Phasenabweichung des Eingangssignals einen festgelegten Grenzwert überschreitet wird das Eingangssignal als fehlerhaft gewertet und dem Oszillator wird ein anderes Referenzsignal oder ein Sollwert zur Frequenzregelung zugeführt.

Vorteilhafte Weiterbildungen sind in den Unteransprüchen angegeben.

Die Erfindung wird anhand von Figuren näher erläutert.

Es zeigen:

Figur 1 ein Prinzipschaltbild eines Phasenregelkreises,
Figur 2 ein Beispiel eines verwendeten Filters und
Figur 3 ein einen Phasenregelkreis mit Umschaltmöglichkeiten.

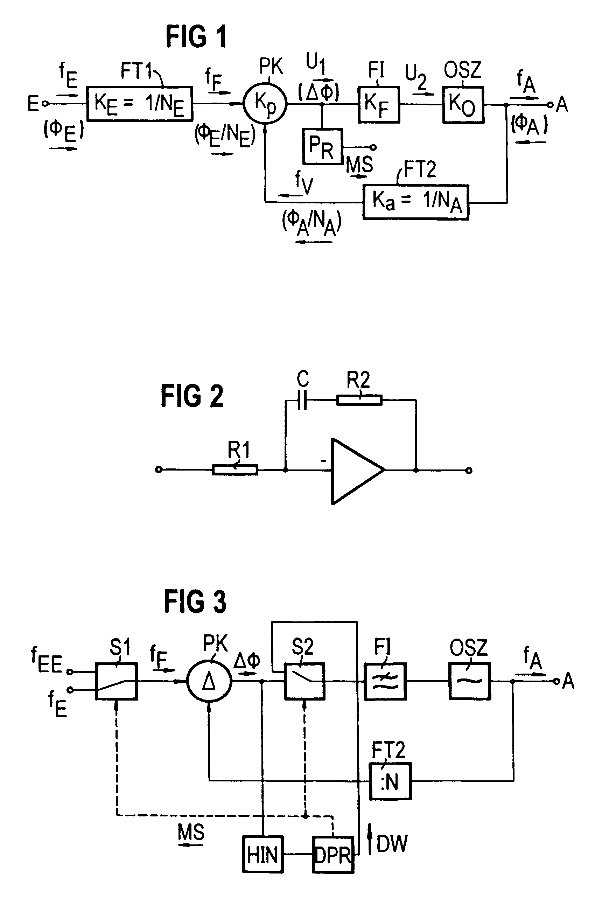

In der Figur 1 ist eine Phasenregelschleife dargestellt. Sie enthält einen Eingangsfrequenzteiler FT1, dem ein Eingangssignal $f_E$ zugeführt wird und der ein Führungssignal $f_F$ abgibt, einen Phasenkomparator PK, dessen erster Eingang mit dem Ausgang des Eingangsfrequenzteilers verbunden ist, ein Filter FI, das an den Ausgang des Phasenkomparators angeschaltet ist und an seinem Ausgang ein Steuersignal U2 für den Oszillator OSZ abgibt, der das Ausgangssignal $f_A$ erzeugt, das am Ausgang A abgegeben wird, und einen Ausgangsfrequenzteiler FT2, der die Frequenz des Ausgangssignals herabteilt und als Vergleichssignal $f_V$ einem zweiten Eingang des Phasenkomparators PK zuführt, der die aktuelle Phasendifferenz $\Delta\Phi$ als Ausgangssignal U1 abgibt. Als Signalbezeichnungen und Frequenzangaben wurden identische Bezugszeichen gewählt, da für die Phasenregelschleife allein die Frequenzen relevant sind.

Die Frequenzteiler FT1 und FT2 sind nicht erforderlich, wenn die Oszillatorfrequenz $f_A$ mit der Frequenz des Eingangssignals $f_E$ übereinstimmt. Häufig werden auch eine höhere Ausgangsfrequenz als die Eingangsfrequenz mit Hilfe des zweiten Frequenzteilers erzeugt, die zum Betrieb des Gerätes erforderlich ist.

An den Ausgang des Phasenkomparators ist außerdem ein Prozessor PR angeschaltet, der zur Berechnung der Änderung der Phase $\Phi_E$ des Führungssignals $f_F$ am Eingang des Phasenkomparators oder des Referenz-Eingangssignals $f_E$ am Eingang des eventuell vorgeschalteten Eingangsfrequenzteilers FT1 dient. Der *Prozessor PR* kann erforderlichenfalls hieraus die Frequenzänderungen dieser Signale berechnen und auch Vergleiche mit Grenzwerten durchführen. Das Ergebnis kann als Steuersignal MS beispielsweise zur Umschaltung auf andere Referenzsignale verwendet werden oder zu Überwachungszwecken aufgezeichnet werden.

Die Funktion der PLL-Schaltung ist aus zahlreichen Veröffentlichungen und Lehrbüchern bekannt. Sie arbeitet als Phasenregelkreis, der durch Steuern des Oszillators OSZ die Vergleichsfrequenz $f_V$ am Phasenkomparator so einstellt, daß sie mit der Frequenz des ebenfalls am Phasenkomparator anliegenden von einem Führungsoszillator erzeugten oder abgeleiteten Führungssignals $f_F$ exakt übereinstimmt, so daß die Phasenabweichung am Ausgang des Phasenkomparators konstant ist.

In der Figur 1 sind sowohl die Frequenzen der Signale, der Mittelwert der Eingangsspannung und die Ausgangsspannung des Filters eingetragen als auch - in der sogenannten Laplace- oder Bilddarstellung - für den eingerasteten Zustand der Phasenregelschleife die entsprechenden Phasen der Signale:

$U_1$    Eingangsspannung des Filters,
$U_2$    Ausgangsspannung des Filters,
$\Phi_E$    Eingangsphase,
$\Phi_A$    Ausgangsphase,
$\Phi_V$    $= \Phi_A/N_A$ Vergleichssignalphase,
$\Delta\Phi$    Phasendifferenz und

die Übertragungsfunktionen der Schaltungseinheiten:

$K_P$    Übertragungsfunktion des Phasenkomparators,
$K_F$    Übertragungsfunktion des Filters,
$K_O$    $= K_V/s$ ($K_V$ = Regelsteilheit) des Oszillators,
$H_E$    $= 1/N_E$ Übertragungsfunktion des Eingangsfrequenzteilers und
$H_A$    $= 1/N_A$ Übertragungsfunktion des Ausgangsfrequenzteilers.

Zunächst soll das Verhalten der Phasenregelschleife und die Berechnung der Eingangsphase beschrieben werden. Als Regler FI wird ein in Figur 2 dargestelltes aktives Filter mit PI-Anteil verwendet. Ein erster Widerstand R1 ist dem Eingang eines Verstärkers vorgeschaltet; ein zweiter Widerstand R2 liegt in Reihe mit einem Kondensator C zwischen dem Filterausgang und dem Verstärkereingang.

Die Berechnung kann für die verschiedenen Filtertypen und Variation der Regelschleifen, beispielsweise bei fehlenden Eingangs- oder Ausgangsteiler entsprechend modifiziert werden.

$$(1) \qquad \Delta\Phi = \frac{\Phi_E}{N_E} - \frac{\Phi_A}{N_A} \Rightarrow (2) \qquad \Phi_E = N_E \Delta\Phi + \frac{N_E}{N_A} \Phi_A$$

$$(3) \qquad U_1(s) = K_P \cdot \Delta\Phi(s) \Rightarrow (4) \qquad U_1(t) = K_P \cdot \Delta\Phi(t)$$

$$(5) \qquad K_F = \frac{U_2}{U_1} = \frac{1 + s\tau_2}{s\tau_1} \Rightarrow (6) \qquad U_2(t) = \frac{\tau_2}{\tau_1} U_1(t) + \frac{1}{\tau_1} \int U_1(t)dt$$

mit $\tau_1 = R1 \cdot C$; $\tau_2 = R2 \cdot C$

$$(7) \qquad \Phi_A(s) = K_0 \frac{U_2(s)}{S} \Rightarrow (8) \qquad \Phi_A(t) = K_0 \int U_2(t)dt$$

mit (4) und (6) in (8) eingesetzt:

$$(9) \qquad \Phi_A(t) = K_0 K_p \frac{\tau_2}{\tau_1} \int \Delta\Phi(t)dt + K_0 K_p \frac{1}{\tau_1} \int dt \int \Delta\Phi(t)dt$$

mit

$$(10) \qquad \omega = \sqrt{\frac{K_0 K_P}{\tau_1}} \qquad (11) \qquad \zeta = \frac{\tau_2}{2} \sqrt{\frac{K_0 K_P}{\tau_1}}$$

in (9) eingesetzt:

$$(12) \qquad \Phi_A(t) = 2\zeta\omega \int \Delta\Phi(t)dt + \omega^2 \int dt \int \Delta\Phi(t)dt$$

(12) in (2) eingesetzt:

$$(13) \qquad \Phi_E(T) = N_E \cdot \Delta\Phi(T) + \frac{N_E}{N_A} \left( 2\zeta\omega_n \int_0^T \Delta\Phi(t)dt + \omega_n^2 \int_0^T dt \int_0^T \Delta\Phi(t)dt \right)$$

Wie in Gleichung (13) angegeben, kann die Phase des Eingangssignals aus der Phasendifferenz und den Parametern der Regelschleife errechnet werden.

Bei den Phasenregelkreisen unterscheidet man - abhängig von der Anzahl der Pole ihrer Übertragungsfunktion - den Typ 1, bei dem im eingerasteten Zustand ein konstanter Phasenunterschied $\Delta\Phi_k$ zwischen den Eingangssignalen des Phasenkomparators vorhanden ist, und den vorstehend beschriebenen Typ 2, bei dem kein Phasenunterschied vorhanden ist.

Beim Typ 1 kann dieser konstante Phasenunterschied $\Delta\Phi_k$ durch dessen Subtraktion vom aktuellen Phasenunterschied $\Delta\Phi_1$ berücksichtigt werden und anschließend dieselbe Berechnung wie beim Typ 2 erfolgen:

$$(14) \qquad \Delta\Phi = \Delta\Phi_1 - \Delta\Phi_k$$

In Figur 3 ist ein Ausführungsbeispiel des Phasenregelkreises mit Umschaltmöglichkeiten auf ein Ersatz-Referenzsignal $f_{EE}$ und einen Referenz-Durchschnittswert DW angegeben.

Zur Umschaltung auf mindestens ein Ersatz-Referenzsignal $f_{EE}$ ist ein erster Umschalter S1 in die Signalleitung des Referenz-Eingangssignals eingeschaltet.

Vor dem Filter FI ist zum Umschalten auf den Referenz-Durchschnittswert ein zweiter Umschalter S2 eingeschaltet, dessen zweiter Eingang mit einem Datenausgang des Digitalprozessors DPR verbunden ist.

Zur Berechnung der Phasenänderung ist an den Ausgang des Phasenkomparators ein digitaler Hardware-Integrator HIN und ein mit diesem verbundener Digitalprozessor DPR angeschlossen.

Der Hardware-Integrator setzt das Ausgangssignal des Phasenkomparators, die Phasendifferenz $\Delta\Phi$, zunächst -

beispielsweise durch Auswerten der Impulslängen des binären Ausgangssignals - in digitale Werte um, summiert diese dann mit jeder Periode des Vergleichssignals oder auch - bei leicht eingeschränkter Genauigkeit - jeweils nur jede zweite oder n-te Periode. Nachdem eine ausreichende Anzahl von Werten der Phasendifferenz summiert worden ist, wird die dem Zeitintegral über die Phasendifferenz $\Delta\Phi$ entsprechende Summe nach Ablauf eines Beobachtungszeitraumes $\Delta t = 0$ bis T in den Digitalprozessor zur Errechnung der Phasenänderung übernommen. Bei der Anwendung in einem Cross-Connector der synchronen digitalen Hierarchie erfolgt dies ca. jede Sekunde. Die Integrationszeit ist einstellbar.

Der Digitalprozessor kann - gewissermaßen im Zeitmultiplexbetrieb - auch jeweils auf längere Beobachtungszeiträume zurückgreifen und in kurzen Abständen Kontrollergebnisse liefern.

Wie bereits eingangs erwähnt, kann auf die Berechnung des Doppelintegrals häufig verzichtet werden, da dies bei größeren Dämpfungen nur einen kleinen Beitrag liefert.

Ergibt die Berechnung eine unzulässige Phasenänderung des Eingangssignals, so führt dies zum Umschalten auf ein Ersatz-Eingangssignal $f_{EE}$ oder - falls ein solches nicht oder nicht mehr zur Verfügung steht - zum sogenannten Speicherbetrieb, in dem der steuerbare Oszillator OSZ über den zweiten Schalter S2 einen entsprechenden Referenz-Durchschnittswert DW der Phasenabweichung **erhält.** Dieser Wert wurde im Digitalprozessor ermittelt und bei einer mit analogen Signalen arbeitenden Phasenregelschleife in einen analogen Wert umgesetzt.

Auch nachdem auf den Speicherbetrieb umgeschaltet worden ist, soll die Phasen- und damit die Frequenzkonstanz des Eingangssignals wie bisher überprüft werden. Diese Aufgabe übernimmt ebenfalls der Prozessor, wobei von einer konstanten Anfangsphasendifferenz $\Delta\Phi$ zwischen dem Referenz-Eingangssignal und **dem vom Referenz-Durchschnittswert** bestimmten Vergleichssignal $f_V$ ausgegangen wird.

Ergibt die Überprüfung, daß die Störung des Eingangssignals vorüber ist und das Eingangssignal wieder die erforderliche Frequenzkonstanz aufweist, dann wird der Speicherbetrieb verlassen und auf das anliegende Eingangssignal umgeschaltet. Die Prüfzeiten sind den Erfordernissen entsprechend einstellbar bzw. programmierbar.

**Patentansprüche**

1. Verfahren zur Ermittlung einer Änderung der Phase ($\Phi_E$) eines Referenz-Eingangssignals ($f_E$) eines Phasenregelkreises (PK, FI, OSZ), der einen Phasenkomparator (PK) zum Ermitteln der Phasendifferenz ($\Delta\Phi$) zwischen dem Referenz-Eingangssignal ($f_E$) und einem erzeugten Vergleichssignal ($f_V$), ein Filter (FI) und einen steuerbaren Oszillator *(OSZ)* aufweist,
   **dadurch gekennzeichnet,**
   daß aus der Phasendifferenz am Ausgang des Phasenkomparators (PK) und den Parametern ($N_E$, $K_P$, $K_F$, $K_O$, $N_A$) des Phasenregelkreises (FT1, PK, FI, OSZ, FT2) die Phasenänderung des Referenz-Eingangssignals ($f_E$) innerhalb eines Beobachtungszeitraumes, z.B. $\Delta t = 0$ bis T, in einem Prozessor (PR) *mittels Integration der Phasendifferenz* ($\Delta\Phi$) errechnet wird.

2. Verfahren nach Anspruch 1,
   **dadurch gekennzeichnet,**
   daß in dem Prozessor die Änderung der Phase $\Phi_E$ aus der Phasendifferenz $\Delta\Phi$ entsprechend

$$\Phi_E(T) = N_E \cdot \Delta\Phi(T) + \frac{N_E}{N_A}\left(2\zeta\omega_n\int_0^T\Delta\Phi(t)dt + \omega_n^2\int_0^T dt\int_0^T\Delta\Phi(t)dt\right)$$

innerhalb eines Beobachtungszeitraumes $\Delta t = 0$ bis T errechnet wird, mit

$\zeta$ = Dämpfung und $\omega_n$ = Eigenfrequenz,
$N_E$ = Teilungsfaktor eines Eingangsfrequenzteilers (FT1), dem das Referenz-Eingangssignal zugeführt wird und dessen Ausgang mit einen ersten Eingang des Phasenkomparators (PK) verbunden ist und
$N_A$ = Teilungsfaktor eines Ausgangsfrequenzteilers (FT2), der die Frequenz des Ausgangssignals herabteilt und als Vergleichssignal einem zweiten Eingang des Phasenkomparators (PK) zuführt.

3. Verfahren nach Anspruch 1,
   **dadurch gekennzeichnet,**
   daß in dem Prozessor (PR) die Änderung der Phase ($\Phi_E$) entsprechend

$$\Phi_E(T) = N_E \cdot \Delta\Phi(T) + \frac{N_E}{N_A}\left(2\zeta\omega_n\int_0^T \Delta\Phi(t)dt\right)$$

errechnet wird.

4. Verfahren nach Anspruch 1,
   **dadurch gekennzeichnet,**
   daß aus der Änderung der Phase ($\Phi_E$) des Referenz-Eingangssignals ($f_E$) seine Frequenzabweichung ermittelt wird.

5. Verfahren nach Anspruch 1,
   **dadurch gekennzeichnet,**
   daß beim Überschreiben der zulässigen Änderung der Phase ($\Phi_E$) des Referenz-Eingangssignals ($f_E$) vom Prozessor (PR) ein Steuersignal (MS) abgegeben wird.

6. Verfahren nach Anspruch 5,
   **dadurch gekennzeichnet,**
   daß durch das Steuersignal (MS) auf ein Ersatz-Referenzeingangssignal ($f_{EE}$) umgeschaltet wird oder ein Referenz-Durchschnittswert (DW) dem Oszillator (OSZ) bei aufgetrenntem Phasenregelkreis zugeführt wird.

7. Anordnung zur Ermittlung einer Änderung der Phase ($\Phi_E$) eines Referenz-Eingangssignals ($f_E$) eines Phasenregelkreises, der einen Phasenkomparator (PK), ein Filter (FI) und einen steuerbaren Oszillator (OSZ) aufweist,
   **dadurch gekennzeichnet,**
   daß an den Ausgang des Phasenkomparators (PK) ein Prozessor (PR) angeschaltet ist, der aus der Phasendifferenz ($\Delta\Phi$) am Ausgang des Phasenkomparators (PK) und den Parametern ($N_E$, $K_P$, $K_F$, $K_O$, $N_A$) des Phasenregelkreises (FT1, PK, FI, OSZ, FT2) die Phasenänderung des Eingangssignals ($f_E$) innerhalb eines Beobachtungszeitraumes, z.B. $\Delta t = 0$ bis T, mittels Integration der Phasendifferenz ($\Delta\Phi$) errechnet und an seinem Steuerausgang ein Steuersignal (MS) abgibt.

8. Anordnung nach Anspruch 7,
   **dadurch gekennzeichnet,**
   daß ein erster Umschalter (S1) in der Zuleitung des Referenz-Eingangssignals ($f_{E4}$) vorgesehen ist, an dessen einem Eingang mindestens ein Ersatz-Referenzsignal ($f_{EE}$) anliegt, und daß beim Überschreiten des Grenzwertes auf das Ersatz-Referenzsignal ($f_{EE}$) umgeschaltet wird.

9. Anordnung nach einem der Ansprüche 7 oder 8,
   **dadurch gekennzeichnet,**

   daß ein zweiter Umschalter (S2) mit einem zweiten Eingang vorgesehen ist, dessen erster Eingang an den Ausgang des Phasenkomparators (PK) angeschlossen ist und dessen Ausgang an das Filter (FI) geführt ist, daß an den zweiten Eingang des zweiten Umschalters (S2) ein im Prozessor (PR; DIN, DPR) berechneter Referenz-Durchschnittswert (DW) geführt ist und daß beim Überschreiten eines einer vorgegebenen Phasenänderung des Referenz-Eingangssignals ($f_E$) entsprechenden Grenzwertes auf einen im Prozessor (PR; DIN, DPR) berechneten Referenz-Durchschnittswert (DW) umgeschaltet wird.

## Claims

1. Method for determining a variation in the phase ($\Phi_E$) of a reference input signal ($f_E$) of a phase-locked loop (PK, FI, OSZ) which has a phase comparator (PK) for determining the phase difference ($\Delta\Phi$) between the reference input signal ($f_E$) and a generated reference signal ($f_v$), a filter (FI) and a controllable oscillator (OSZ), characterized in that the phase variation in the *reference* input signal ($f_E$) within an observation period, for example $\Delta t = 0$ to T, is calculated in a processor (PR) *by means of integration of the phase difference* ($\Delta\Phi$) from the phase difference at the output of the phase comparator (PK) and from the parameters ($N_E$, $K_P$, $K_F$, $K_0$, $N_A$) of the phase-locked loop (FT1, PK, FI, OSZ, FT2).

2. Method according to Claim 1, characterized in that the change in the phase $\Phi_E$ is calculated in the processor within an observation period $\Delta t = 0$ to $T$ from the phase difference $\Delta\Phi$ in accordance with

$$\Phi_E(T) = N_E \cdot \Delta\Phi(T) + \frac{N_E}{N_A}\left(2\zeta\omega_n\int_0^T \Delta\Phi(t)dt + \omega_n^2\int_0^T dt\int_0^T \Delta\Phi(t)dt\right)$$

where

$\zeta$ = attenuation and $\omega_n$ = natural frequency,
$N_E$ = division ratio of an input frequency divider (FT1), to which the reference input signal is fed and whose output is connected to a first input of the phase comparator (PK) and
$N_A$ = division ratio of an output frequency divider (FT2), which divides down the frequency of the output signal, and feeds it as reference signal to a second input of the phase comparator (PK).

3. Method according to Claim 1, characterized in that the variation in the phase ($\Phi_E$) is calculated in the processor (PR) in accordance with

$$\Phi_E(T) = N_E \cdot \Delta\Phi(T) + \frac{N_E}{N_A}\left(2\zeta\omega_n\int_0^T \Delta\Phi(t)dt\right)$$

4. Method according to Claim 1, characterized in that the frequency deviation of the reference input signal ($f_E$) is determined from the variation in its phase ($\Phi_E$).

5. Method according to Claim 1, characterized in that a control signal (MS) is emitted by the processor (PR) upon overshooting of the permissible variation in the phase ($\Phi_E$) of the reference input signal ($f_E$).

6. Method according to Claim 5, characterized in that the control signal (MS) causes a switchover to an equivalent reference input signal ($f_{EE}$), or causes a reference mean value (DW) to be fed to the oscillator (OSZ) with the phase-locked loop open.

7. Arrangement for determining a variation in the phase ($\Phi_E$) of a reference input signal ($f_E$) of a phase-locked loop which has a phase comparator (PK), a filter (FI) and a controllable oscillator (OSZ), characterized in that connected to the output of the phase comparator (PK) is a processor (PR) which determines the phase variation in the input signal ($f_E$) within an observation period, for example $\Delta t = 0$ to $T$, from the phase difference ($\Delta\Phi$) at the output of the phase comparator (PK) and the parameters ($N_E$, $K_P$, $K_F$, $K_O$, $N_A$) of the phase-locked loop (FT1, PK, FI, OSZ, FT2) by means of integrating the phase difference ($\Delta\Phi$), and emits a control signal (MS) at its control output.

8. Arrangement according to Claim 7, characterized in that provided in the supply lead of the reference input signal ($f_{E4}$) is a first changeover switch (S1), at one input of which at least one equivalent reference signal ($f_{EE}$) is present, and in that a switchover is made to the equivalent reference signal ($f_{EE}$) upon overshooting of the limiting value.

9. Arrangement according to one of Claims 7 or 8, characterized in that a second changeover switch (S2) having a second input is provided, whose first input is connected to the output of the phase comparator (PK) and whose output is led to the filter (FI), in that the reference mean value (DW) calculated in the processor (PR; DIN, DPR) is led to the second input of the second changeover switch (S2), and in that the switchover is made to a reference mean value (DW) calculated in the processor (PR; DIN, DPR) upon overshooting of a limiting value corresponding to a prescribed phase variation in the reference input signal ($f_E$).

**Revendications**

1. Procédé de détermination d'une variation de la phase ($\Phi_E$) d'un signal d'entrée de référence ($f_E$) d'une boucle à verrouillage de phase (PK, FI, OSZ) qui comporte un comparateur de phase (PK) pour déterminer la différence de phase ($\Delta\Phi$) entre le signal d'entrée de référence ($f_E$) et un signal de comparaison produit ($f_v$), un filtre (FI) et un oscillateur (OSZ) pouvant être commandé,

caractérisé par le fait que

l'on calcule dans un processeur (PR) au moyen de l'intégration de la différence de phase ($\Delta\Phi$) à partir de la différence de phase à la sortie du comparateur de phase (PK) et à partir des paramètres ($N_E$, $K_P$, $K_F$, $K_O$, $N_A$) de la boucle à verrouillage de phase (FT1, PK, FI, OSZ, FT2), la variation de phase du signal d'entrée de référence ($f_E$) pendant un intervalle de temps d'observation, par exemple $\Delta t = 0$ à T.

2. Procédé selon la revendication 1,

caractérisé par le fait que

l'on calcule dans le processeur à partir de la différence de phase ($\Delta\Phi$) la variation de la phase $\Phi_E$ :

$$\Phi_E(T) = N_E \cdot \Delta\Phi(T) + \frac{N_E}{N_A}[2\zeta\omega_n \int_0^T \Delta\Phi(t)\,dt + \omega_n^2 \int_0^T dt \int_0^T \Delta\Phi(t)\,dt]$$

pendant un intervalle de temps d'observation $\Delta t = 0$ à T, avec

$\zeta$ = affaiblissement et on = fréquence propre,

$N_E$ = facteur de division d'un diviseur de fréquence d'entrée (FT1) auquel est envoyé le signal d'entrée de référence et dont la sortie est reliée à une première entrée du comparateur de phase (PK), et

$N_A$ = facteur de division d'un diviseur de fréquence de sortie (FT2) qui divise la fréquence du signal de sortie et qui envoie le résultat comme signal de comparaison à une seconde entrée du comparateur de phase (PK).

3. Procédé selon la revendication 1,

caractérisé par le fait que

l'on calcule dans le processeur (PR) la variation de la phase ($\Phi_E$) :

$$\Phi_E(T) = N_E \cdot \Delta\Phi(T) + \frac{N_E}{N_A}[2\zeta\omega_n \int_0^T \Delta\Phi(t)\,dt]$$

4. Procédé selon la revendication 1,

caractérisé par le fait que

l'on détermine à partir de la variation de la phase ($\Phi_E$) du signal d'entrée de référence ($f_E$) son écart de fréquence.

5. Procédé selon la revendication 1,

caractérisé par le fait que,

en cas de dépassement de la variation admissible de la phase ($\Phi_E$) du signal d'entrée de référence ($f_E$), le processeur (PR) fournit un signal de commande (MS).

6. Procédé selon la revendication 5,

caractérisé par le fait que,

au moyen du signal de commande (MS), on commute sur un signal d'entrée de référence de remplacement ($f_{EE}$) ou on envoie une valeur moyenne de référence (DW) à l'oscillateur (OSZ) dans le cas d'une boucle à verrouillage de phase séparée.

7. Dispositif de détermination d'une variation de la phase ($\Phi_E$) d'un signal d'entrée de référence ($f_E$)

à la sortie du comparateur de phase (PK), il est branché un processeur (PR) qui calcule au moyen d'une intégration de la différence de phase ($\Delta\Phi$) à partir de la différence de phase ($\Delta\Phi$) à la sortie du comparateur de phase (PK) et à partir des paramètres ($N_E$, $K_P$, $K_F$, $K_O$, $N_A$) de la boucle à verrouillage de phase (FT1, PK, FI, OSZ, FT2) la variation de phase du signal d'entrée ($f_E$) pendant un intervalle de temps d'observation, par exemple

$\Delta t = 0$ à T, et qui fournit à sa sortie de commande un signal de commande (MS).

8. Dispositif selon la revendication 7,
caractérisé par le fait que
l'on prévoit dans la ligne d'amenée du signal d'entrée de référence ($f_E$) un premier commutateur (S1) à une entrée duquel est appliqué au moins un signal de référence de remplacement ($f_{EE}$) et que, en cas de dépassement de la valeur limite, on commute sur le signal de référence de remplacement ($f_{EE}$).

9. Dispositif selon l'une des revendications 7 ou 8,
caractérisé par le fait que

l'on prévoit un second commutateur (S2) qui comporte une seconde entrée et dont la première entrée est raccordée à la sortie du comparateur de phase (PK) et dont la sortie est envoyée au filtre (FI),
une valeur moyenne de référence (DW) calculée dans le processeur (PR ; HIN, DPR) est envoyée à la seconde entrée du second commutateur (S2), et que,
en cas de dépassement d'une valeur limite correspondant à une variation de phase prédéterminée du signal d'entrée de référence ($f_E$), on commute sur une valeur moyenne de référence (DW) calculée dans le processeur (PR ; HIN, DPR).

## FIG 1

## FIG 2

## FIG 3